# EUROPÄISCHE PATENTSCHRIFT

(11) **EP 1 114 539 B1**
(45) Veröffentlichungstag und Bekanntmachung des Hinweises auf die Patenterteilung: **03.12.2003**
(21) Anmeldenummer: 99953656.8
(22) Anmeldetag: 01.09.1999
(51) Int. Cl.: H04L 7/033, H03L 7/07

(54) **SCHALTUNG ZUR DATENSIGNALRÜCKGEWINNUNG UND TAKTSIGNALREGENERIERUNG**
CIRCUIT FOR RECOVERING A DATA SIGNAL AND REGENERATING A CLOCK SIGNAL
CIRCUIT POUR LA RECUPERATION D'UN SIGNAL DE DONNEES ET LA REGENERATION D'UN SIGNAL D'HORLOGE

(30) Priorität: 17.09.1998 DE 19842711
(43) Veröffentlichungstag der Anmeldung: 11.07.2001
(73) Patentinhaber: Infineon Technologies AG, 81669 München (DE)
(72) Erfinder: FRIEDRICH, Dirk, D-80798 München (DE); ROZMANN, Michael, D-82223 Eichenau (DE)
(74) Vertreter: Fischer, Volker, Dipl.-Ing.
(86) Internationale Anmeldenummer: DE9902742
(87) Internationale Veröffentlichungsnummer: WO00018008

(56) Entgegenhaltungen:
- WO-A-98/10519
- GB-A- 1 531 632
- PATENT ABSTRACTS OF JAPAN vol. 1998, no. 02, 30. Januar 1998 (1998-01-30) & JP 09 284126 A (SONY CORP), 31. Oktober 1997 (1997-10-31)
- PATENT ABSTRACTS OF JAPAN vol. 012, no. 395 (E-671), 20. Oktober 1988 (1988-10-20) & JP 63 136718 A (HITACHI LTD), 8. Juni 1988 (1988-06-08)
- PATENT ABSTRACTS OF JAPAN vol. 012, no. 244 (E-631), 9. Juli 1988 (1988-07-09) & JP 63 031314 A (TOSHIBA CORP), 10. Februar 1988 (1988-02-10)

## Beschreibung

Die Erfindung betrifft eine in einem elektronischen Baustein (Chip) vollständig integrierbare Schaltung zur Datensignalrückgewinnung und Taktsignalregenerierung aus einem eingehenden seriellen Datensignalstrom unter Verwendung einer mit einem spannungsgesteuerten Oszillator (VCO; Voltage Controlled Oscillator) versehenen PLL(Phase Locked Loop)-Regelstufe, welcher der serielle Datensignalstrom zugeführt wird, mit einer Retiming-Schaltung.

Die Erfindung richtet sich insbesondere auf die Rückgewinnung bzw. das Retiming von Daten- und Taktsignalen aus seriellen Datenströmen z.B. bei Transceiver-Schaltungen für ATM(Asynchroner Transfermodus)-, SONET(Synchronous Optical Network; Synchrones optisches Netz)- und SDH(Synchrone Digitale Hierarchie)-Anwendungen.

Es ist bekannt, die Wiederaufbereitung von Daten- und Taktsignalen mit Hilfe einer PLL-Regelstufe und eines Retiming-Flip-Flops zu realisieren. Hierzu gibt es die verschiedensten Arten von Phasen- und Frequenzdetektoren. In diesem Zusammenhang wird auf den Aufsatz von Herzog, Hans-Jürgen: "Auswahl von Bausteinen für die Daten- und Taktregenerierung in Telekom- und Datennetzen", erschienen in der Zeitschrift "HF-Praxis", Heft 5, 1998, Jahrgang 4, S. 12-14, hingewiesen.

Bei dem eingehenden Datensignal handelt es sich in der Regel um eine mit Rauschen und Jitter behaftete serielle Bitfolge. An einen diesen Datensignalstrom empfangenden und auswertenden Transceiver werden verschiedene Anforderungen gestellt, damit ausgangsseitig wieder ein Signal von geforderter Güte entsteht. Zwei wichtige Anforderungen, die sich jedoch teilweise widersprechen, sind dabei die Werte für die Jitter-Toleranz und für den Jitter-Transfer. Die Jitter-Toleranz definiert den maximal zulässigen Eingangsjitter, den die Schaltung noch fehlerfrei verarbeiten kann. Dieser Wert sollte möglichst groß sein. Der Jitter-Transfer definiert den maximal zulässigen Jitter, der vom Eingang zum Ausgang übertragen werden darf. Dieser sollte möglichst klein sein.

Um diese Jitter-Anforderungen zu erfüllen, muß man die Bandbreite der bei der Wiederaufbereitung von Daten- und Taktsignalen eingesetzten PLL-Regelschleife an die Erfordernisse anpassen. Für eine große Jitter-Toleranz ist eine große PLL-Regelschleifenbandbreite nötig.

Eine große Bandbreite ermöglicht der PLL-Regelschleife ein schnelles Folgen in der Frequenz und in der Phase des eingehenden Signals und somit ein zuverlässiges Abtasten in der zeitlichen Mitte eines Datenbits. Diese Tatsache hat dann auch eine große Eingangsempfindlichkeit der Schaltung zur Folge.

Für einen geringen Jitter-Transfer ist eine kleine PLL-Regelschleifenbandbreite erforderlich. Dadurch wird gewährleistet, daß die PLL-Regelstufe nicht dem hochfrequenten Jitter, Rauschen und sonstigen Störungen folgt und damit die Qualität des rückgewonnenen Datensignals beeinträchtigt.

Um beide Bedingungen zugleich einigermaßen zu erfüllen, ist man somit gezwungen, einen Kompromiß einzugehen. Die Bandbreite einer solchen PLL-Regelschleife liegt dabei in einem recht engen Bereich. Da eine PLL-Regelstufe zum Teil aus stark nichtlinearen Komponenten bestehen kann, besonders bei vollständig integrierten PLL-Regelschleifen, ist eine Berechnung bzw. Realisierung der Bandbreite schwierig.

Jitter-Unterdrückung mit zwei in Reihe geschalteten PLL-Regalsfufen, wobei eingangsseitig der ersten PLL-Stufe als Eingangssignal lediglich ein Taktsignal zugeführt wird, ist in GB-A-1 531 632 offenbart. Ein ähnliche Schaltung ist aus JP 9-284 126 bekannt.

Der Erfindung liegt die Aufgabe zugrunde, eine vollständig auf einem elektronischen Chip integrierbare und damit ohne äußere Beschaltung implementierbare Schaltung zur Rückgewinnung bzw. zum Retiming von Daten- und Taktsignalen aus seriellen Datenströmen insbesondere für einen einfacheren Aufbau von ATM-, SONET- und SDH-konformen Transceiver-Schaltungen bei einer Einsatzmöglichkeit in Signalübertragungsstrecken im Gigabit-Bereich zu schaffen, wobei die Jitter-Anforderungen eingehalten werden und somit ausgangsseitig wieder ein Datensignal von geforderter Güte, also vorgeschrieben niedriger Bitfehlerrate, entsteht.

Diese Aufgabe wird gemäß der Erfindung, die sich auf eine Schaltung der eingangs genannten Art bezieht, dadurch gelöst, daß der PLL-Regelstufe eine zweite PLL-Regelstufe in Serie nachgeschaltet ist, daß die beiden PLL-Regelstufen unabhängig sind und jeweils getrennt optimal einstellbar sind, daß die erste PLL-Regelstufe so eingestellt ist, daß sie eine große Bandbreite aufweist und auf eine möglichst große Jitter-Toleranz optimiert ist, und daß die zweite PLL-Regelstufe so eingestellt ist, daß sie eine geringe Bandbreite aufweist und auf einen möglichst geringen Jitter-Transfer optimiert ist.

Die Erfindung löst also das Problem, indem zwei unabhängige PLL-Regelstufen in Serie geschaltet werden, für die jeweils getrennt die optimale Einstellung vorgenommen wird. Die erste PLL-Regelstufe hat eine große Bandbreite und regeneriert den Pegel des eingehenden Signals.

Damit wird das Signal/Rausch-Verhältnis unkritischer und die zweite PLL-Regelstufe kann eine fehlerfreie Datenregenerierung garantieren, auch ohne in der absoluten Mitte eines Datenbits abzutasten. Die zweite PLL-Regelstufe hat eine geringe Bandbreite und kann somit auf einen geringen Jitter-Transfer optimiert werden.

Die vollständige Integration auf einem einzigen Chip ist möglich, da die Schaltung nach der Erfindung größere Parameterschwankungen der Schaltung tolerieren kann.

In vorteilhafter Weise ist der Übergang von der ersten PLL-Regelstufe auf die zweite PLL-Regelstufe durch eine in der zweiten PLL-Regelstufe ausgeführte Synchronisation der beiden Taktsignale vorgenommen. Die zweite PLL-Regelstufe läßt sich einfach und ohne großen technischen Schaltungsaufwand verwirklichen.

Die Referenzfrequenz der ersten PLL-Regelstufe ist zweckmäßig durch einen frequenzkonstanten Quarzoszillator stabilisiert.

Im folgenden wird anhand eines in einer FIGUR dargestellten Blockschaltbildes eine Schaltung zur Datensignalrückgewinnung und Taktsignalregenerierung nach der Erfindung erläutert.

Über einen Trennverstärker 1 wird ein eingehender digitaler Datenstrom DATA IN einer ersten PLL-Regelstufe 2 zugeführt. Die Referenzfrequenz f_{Ref} der PLL-Regelstufe 2 wird durch einen Quarzoszillator 3 gebildet, ist deswegen frequenzstabil und hält einen spannungsgesteuerten Oszillator in einem gültigen Arbeitsbereich.

Die erste PLL-Regelstufe 2 ist mit einem spannungsgesteuerten Oszillator (VCO) 4, der beispielsweise durch einen Ringoszillator realisiert werden kann, und einem Integrator 5 versehen, mit dem die Bandbreite der PLL-Regelstufe 2 bestimmt wird, versehen. Der ersten PLL-Regelstufe 2 ist eine zweite PLL-Regelstufe 6 nachgeschaltet, die ebenfalls mit einem spannungsgesteuerten Oszillator 7 und einem Integrator 8 versehen ist, durch den die Bandbreite der zweiten PLL-Regelstufe 6 maßgeblich bestimmt wird.

Über jeweils einen Trennverstärker 9 bzw. 10 werden die endgültig rückgewonnenen Daten- und Taktsignale DATA OUT bzw. CLOCK OUT aus der zweiten PLL-Regelstufe 6 herausgeführt. Für die beiden unabhängigen PLL-Regelstufen 2 und 6 wird die optimale Einstellung jeweils getrennt vorgenommen. Die erste PLL-Regelstufe 2 hat eine große Bandbreite und regeneriert den Pegel des eingehenden Signals DATA IN.

Das Signal/Rausch-Verhältnis wird dadurch unkritischer; und die zweite PLL-Regelstufe 6 stellt eine fehlerfreie Datenrückgewinnung sicher, wobei von ihr nicht unbedingt in der absoluten Mitte der Datenbits der von der ersten PLL-Regelstufe 2 zugeführten Datensignale DATA abgetastet werden muß.

Die zweite PLL-Regelstufe 6 hat im Gegensatz zur ersten PLL-Regelstufe 2 eine geringe Bandbreite und läßt sich auf einen moglichst geringen Jitter-Transfer optimieren. Der Übergang von der ersten PLL-Regelstufe 2, in welcher die Datensignale DATA und Taktsignale CLOCK wiedergewonnen werden, erfolgt durch eine Synchronisation der beiden Taktsignale CLOCK und CLOCK OUT in der relativ einfach zu realisierenden PLL-Regelstufe 6.

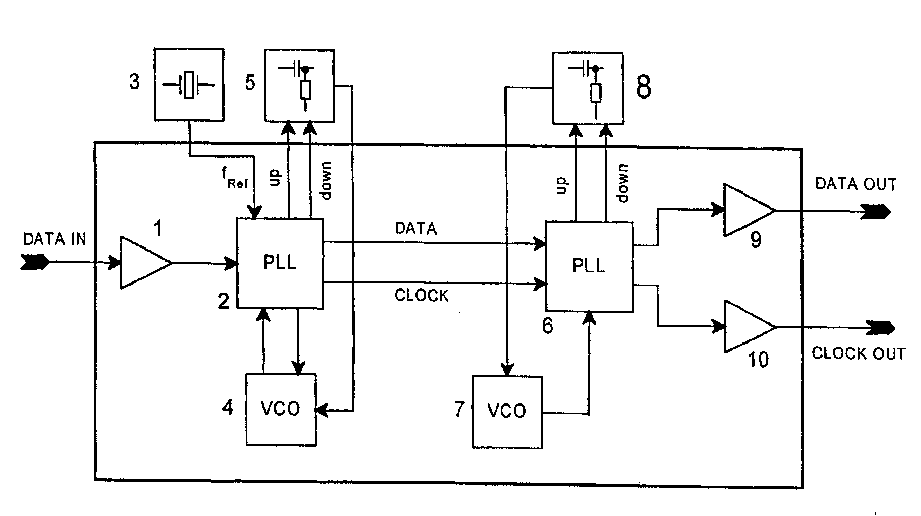

## Patentansprüche

1. Schaltung, die in einem elektronischen Baustein (Chip) vollständig integrierbar ist, zur Datensignalrückgewinnung und Taktsignalregenerierung aus einem eingehenden seriellen Datenbits umfassenden Datensignalstrom (DATA IN) unter Verwendung einer mit einem spannungsgesteuerten Oszillator (VCO; Voltage Controlled Oscillator) versehenen PLL(Phase Locked Loop)-Regelstufe, welcher eingangsseitig der serielle Datensignalstrom (DATA IN) zugeführt wird und welche ausgangsseitig ein Taktsignal (CLOCK) erzeugt, mit einer Retiming-Schaltung, wobei der PLL-Regelstufe (2) eine zweite PLL-Regelstufe (6) in Serie nachgeschaltet ist, welcher eingangsseitig das Taktsignal (CLOCK) zuführbar ist und welche ausgangsseitig ein Ausgangstaktsignal (CLOCK OUT) erzeugt, wobei die beiden PLL-Regelstufen (2, 6) unabhängig sind und jeweils getrennt optimal einstellbar sind, wobei die erste PLL-Regelstufe (2) so eingestellt ist, daß sie eine erste Bandbreite aufweist, und wobei die zweite PLL-Regelstufe (6) so eingestellt ist, daß sie eine zweite verglichen mit der ersten geringere Bandbreite aufweist.

2. Schaltung nach Anspruch 1,
**dadurch gekennzeichnet, daß**
der Übergang von der ersten PLL-Regelstufe (2) auf die zweite PLL-Regelstufe (6) durch eine in der zweiten PLL-Regelstufe realisierte Synchronisation der beiden Taktsignale (CLOCK, CLOCK OUT) vorgenommen ist.

3. Schaltung nach Anspruch 1 oder 2,
**dadurch gekennzeichnet, daß**
eine Referenzfrequenz (f_{Ref}) der ersten PLL-Regelstufe (2) durch einen frequenzkonstanten Quarzoszillator (5) stabilisiert ist.

4. Schaltung nach einem der vorhergehenden Ansprüche,
**gekennzeichnet durch**
die Anwendung in Transceiver-Schaltungen am Ende von Übertragungsstrecken eines Telekommunikations- und Datenübertragungsnetzes.

5. Schaltung nach einem der vorhergehenden Ansprüche,
**gekennzeichnet durch,**
einen Einsatz in Signalübertragungsstrecken im Gigabit-Bereich.

## Claims

1. Circuit, which can be completely integrated in an electronic module (chip), for data signal recovery and clock signal regeneration from an incoming serial data signal stream (DATA IN) comprising data bits, using a PLL (Phase Locked Loop) regulating stage which is provided with a voltage-controlled oscillator (VCO) and to which the serial data signal stream (DATA IN) is fed on the input side and which generates a clock signal (CLOCK) on the output side, having a retiming circuit, there being connected downstream of the PLL regulating stage (2) in series a second PLL regulating stage (6), to which the clock signal (CLOCK) can be fed on the input side and which generates an output clock signal (CLOCK OUT) on the output side, the two PLL regulating stages (2, 6) being independent and each being optimally adjustable separately, the first PLL regulating stage (2) being set in such a way that it has a first bandwidth, and the second PLL regulating stage (6) being set in such a way that it has a second bandwidth, smaller than the first bandwidth.

2. Circuit according to Claim 1,
**characterized in that**
the transition from the first PLL regulating stage (2) to the second PLL regulating stage (6) is performed by means of synchronization of the two clock signals (CLOCK, CLOCK OUT) which is realized in the second PLL regulating stage.

3. Circuit according to Claim 1 or 2,
**characterized in that**
a reference frequency (f_{Ref}) of the first PLL regulating stage (2) is stabilized by a frequency-constant crystal oscillator (5).

4. Circuit according to one of the preceding claims,
**characterized by**
application in transceiver circuits at the end of transmission links of a telecommunications and data transmission network.

5. Circuit according to one of the preceding claims,
**characterized by**
use in signal transmission links in the gigabit range.

## Revendications

1. Circuit qui peut être entièrement intégré dans un module (puce) électronique et qui est destiné à la récupération d'un signal de données et à la régénération d'un signal d'horloge à partir d'un flux ( DATA IN) de signal de données entrant sériel et comprenant des bits de données, en utilisant un étage de régulation PLL (Phase Locked Loop) muni d'un oscillateur (VCO, Voltage Controlled Oscillator) commandé par tension, auquel est envoyé, du côté entrée, le flux (DATA IN) sériel de signal de données et qui produit, du côté sortie, un signal (CLOCK) d'horloge comprenant un circuit de retiming, un deuxième étage (6) de régulation PLL étant monté en série en aval de l'étage (2) de régulation PLL, le signal (CLOCK) d'horloge pouvant lui être envoyé du côté entrée et il produit du côté sortie un signal (CLOCK OUT) d'horloge de sortie et les deux étages (2, 6) de régulation PLL étant indépendants et pouvant être réglés d'une manière la meilleure possible respectivement séparément, le premier étage (2) de régulation PLL étant réglé de manière à ce qu'il ait une première largeur de bande et le deuxième étage (6) PLL étant réglé de manière à ce qu'il ait une deuxième largeur de bande plus petite que la première.

2. Circuit suivant la revendication 1,
**caractérisé en ce que** le passage du premier étage (2) de régulation PLL au deuxième étage (6) de régulation PLL s'effectue par une synchronisation, réalisée dans le deuxième étage de régulation PLL, des deux signaux (CLOCK, CLOCK OUT) d'horloge.

3. Circuit suivant la revendication 1 ou 2,
**caractérisé en ce qu'**une fréquence (f_{réf}) de référence du premier étage (2) de régulation PLL est stabilisée par un oscillateur (5) à quartz à fréquence constante.

4. Circuit suivant l'une des revendications précédentes,
**caractérisé par** l'utilisation dans des circuits émetteurs à l'extrémité de sections de transmission d'un réseau de télécommunication et de transmission de données.

5. Circuit suivant l'une des revendications précédentes,
**caractérisé par** une utilisation dans des sections de transmission de signal de l'ordre du gigabit.
